(19) **Europäisches Patentamt**

**European Patent Office**

**Office européen des brevets**

(11) **EP 0 936 627 B1**

(12) **EUROPEAN PATENT SPECIFICATION**

(45) Date of publication and mention
of the grant of the patent:
**20.10.2004   Bulletin 2004/43**

(51) Int Cl.7: **G11C 16/06**, G11C 7/06

(21) Application number: **98830064.6**

(22) Date of filing: **13.02.1998**

(54) **Low voltage non volatile memory sense amplifier**

Abfühlverstärker für nichtflüchtigen Speicher mit niedriger Spannung

Amplificateur de détection pour mémoire non volatile à basse tension

(84) Designated Contracting States:
**DE FR GB IT**

(43) Date of publication of application:
**18.08.1999   Bulletin 1999/33**

(73) Proprietor: **STMicroelectronics S.r.l.**
**20041 Agrate Brianza (Milano) (IT)**

(72) Inventors:
• **Gaibotti, Maurizio**
**20031 Cesano Maderno (MI) (IT)**

• **Demange, Nicolas**
**57160 Lessy (FR)**

(74) Representative: **Dini, Roberto, Dr. Ing. et al**
**c/o Metroconsult S.r.l.**
**Piazza Cavour 3**
**10060 None (Torino) (IT)**

(56) References cited:
**EP-A- 0 814 484**          **FR-A- 2 623 932**

**Description**

The present invention refers to a sense amplifier circuit for low-voltage non-volatile memories. In the following, reference is made to conventional terms of the MOS (Metal Oxide Semiconductor) transistor technology.

In particular the word 'gate' indicates the control electrode, or control gate, of the MOS transistor, while the word 'drain' indicates the load electrode and the word 'source' the source electrode. With 'non-volatile' memories the memories are meant, which do not lose the stored data when the circuit supply is off; memories of this kind are the ROM (Read Only Memory), the EPROM (Erasable Programmable Read Only Memory), the EEPROM (Electrically Erasable Programmable Read Only Memory) and the EAROM (Electrically Alterable Read Only Memory).

In the EEPROM, in particular, the data to be memorized is stored substantially by means of a MOS transistor. Said MOS transistor comprises two gate electrodes, one being a control gate, electrically connected to the circuit and which receives the gate voltage, the other being a so called floating gate, separated from the control gate by means of an $SiO_2$ oxide barrier, into which it is buried.

Depending on the logic state to be memorized, by means of the application of appropriate voltages, a positive or negative charge is trapped inside the floating gate In fact said charge is transferred by tunnel effect from the substrate to the floating gate, through the potential barrier built by the oxide layer, and trapped therein. The trapped charge acts on the voltage-current relationship of the transistor, so that a change of the threshold voltage of the transistor takes place, according to the type of the trapped charge inside the floating gate As a consequence of the threshold change the memory cell formed by the MOS transistor may assume three different status, i e. written, erased or virgin status, depending on the fact that the charge inside the floating gate is of one or the other type, or a charge has never been there.

The correlation between the logic state, the sign of the trapped charge and the cell status, written or erased, is a matter of choice and may change from a product to another according to the selected convention.

The logic state of a cell can be identified sensing the current flowing through it in known bias conditions. In fact, if a negative charge is trapped inside the floating gate, the transistor threshold is higher in respect of that of a virgin transistor, therefore with the same gate-source voltage a smaller current will flow. Viceversa, if a positive charge is trapped inside the floating gate, the threshold voltage is lower in respect of that of a virgin transistor, and the current is greater In fact, the detection of the logic state is made comparing the current of a cell to the current of a virgin cell in the same biasing conditions. The comparison is made by means of a so called sense amplifier.

The known sense amplifiers are substantially based on a current mirror arranged between two circuit branches, the one connected to a virgin cell and the other to a memory cell.

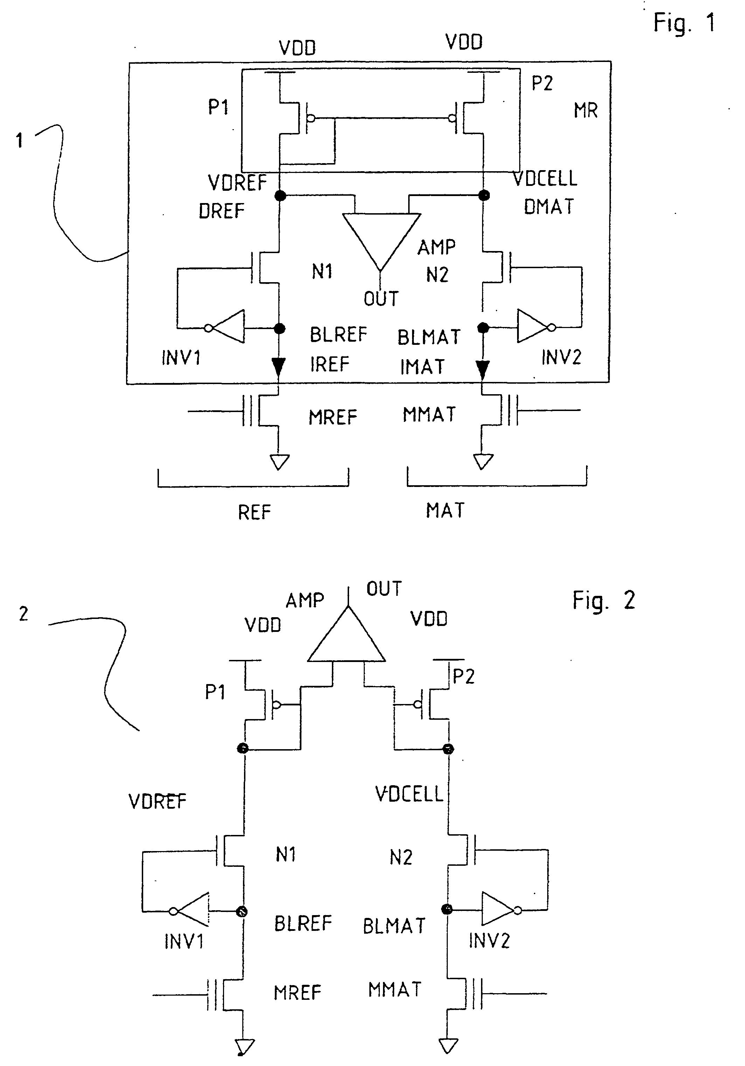

In fig. 1 a known sense amplifier is shown. We can see that it is a substantially symmetric circuit, having a reference branch REF and a second branch pertaining to a cell array MAT. To the reference branch REF there is connected a reference cell MREF, which consists of a floating gate transistor. Said reference cell MREF is a virgin cell. To the branch pertaining to the cell array MAT there is connected a selected cell NMAT. Said refrence cell MREF and selected cell NMAT are both connected to the sense amplifier circuit 1 through respectively a reference bitline BLREF and an array bitline DRMAT. Said selected cell NMAT is one the cells of a memory array which is not shown in its entirety for the sake of simplicity The memory array cells are connected to the bitline of the array BLMAT by means of their drains and each selected cell NMAT is selected through a suitable decoding circuit, not shown too

A reference current IREF flows through the reference cell MREF and is mirrored by the amplifier circuit 1 into the branch of the cell array MAT

The amplifier circuit 1, in the reference branch REF, is represented by a N-channel MOS transistor N1, with the gate connected to an inverter INV1, which is controlled by the signal present on the bitline BLREF. In this way a determined voltage, called VBLREF, is fixed on the bitline BLREF, said determined voltage VBLREF being also the voltage on the drain of the reference cell MREF. Said determined voltage VBLREF shall have such a value that between source and drain a voltage VDSREF is to be found, sufficient to keep the reference cell MREF conducting. The voltage VBLREF depends on the threshold voltage of the inverter INV1 and the threshold voltage VTN1 of transistor N1.

Between a supply voltage VDD and the drain of transistor N1, there is connected, as a load, a P-type MOS transistor P1 Transistor P1 has gate and drain connected together, in diode configuration, so as to mirror the reference current IREF into the branch pertaining to the cell array MAT, through a corresponding P-type transistor P2.

Transistor P1 and transistor P2 build therefore a current mirror MR. Voltages VDREF and VDCELL respectively available on the transistor N 1 drain, which we will call DREF node, and on the transistor N2 drain, which we will call DMAT node, are then brought to an amplifying stage AMP. The remaining part of the branch of the cell array MAT, completely similar to the reference branch REF, will not be described in detail.

It is therefore clear that the sense amplifier 1 performs substantially the comparison between the reference current IREF and the cell current IMAT, obtaining two corresponding voltages VDREF and VDMAT, which are then sent to the amplifying stage.

Looking at the sense amplifier 1, we see that, for a correct operation of the reference branch REF, we shall have for the supply voltage VDD:

$$VDD > VBLREF + VDSN1 + |VTP| + OVP1 \qquad (1)$$

where

VDSN1 is the necessary drain-source voltage of transistor N1, which is saturated in order to supply the reference current IREF;

VTP1 is the threshold voltage of transistor P1 and

OVP1 is the overdrive voltage necessary to supply the reference current IREF.

In this way, as DREF node is connected to the positive terminal of the amplifying stage AMP, and consequently DMAT node is connected to the negative terminal thereof, the voltage VDREF at nodenode DREF shall be comprised in the range :

$$VBLREF + VDSN1 < VDREF < VDD - |VTP1| - OVP1 \qquad (2)$$

Further, the voltage VDREF shall be allowed to vary through a sufficient range, because it is compared to the voltage VDMAT at nodenode DMAT

If the selected cell MMAT requires a current IMAT, greater than the reference current IREF, then the voltage VDMAT is less than the voltage VDREF and viceversa From equations (1) and (2) it derives that the supply voltage VDD shall be at least greater than 2 volts, in order to allow contemporarily a correct operation of the reference branch REF (or of the cell array MAT branch) and a sufficient variation voltage VDREF (or VDMAT).

In fig. 2 there is shown a sense amplifier 2, substantially similar to the preceding one, in which however two identical sense branches are provided, and the final amplifying stage AMP compares the voltages at the nodes DREF and DMAT.

This sense amplifier circuit however has the same disadvantage as the preceding one, i. e the supply voltage has to be chosen having a suitably high value in order to allow a correct operation.

Said disadvantage is particularly serious in the modern memory circuits, where one tries to reduce the supply voltage in order to reduce the energy consumption thereof.

From European Patent EP-A-0 814 484 A1, on which the preamble of claim 1 is based, a circuit is known for compensating spread effects due to distance between array and reference cells, that uses cascaded mirrors to this purpose. By compensating spread effect accurate threshold voltage regulation, and hence voltage supply regulation is obtained. However, the inconvenient of the supply voltage range limitation on the reference branch is not solved. The present invention has the aim of fixing the above cited problems and of indicating a sense amplifier for low-voltage non-volatile memories, the implementation of which is more effective and improved.

Within this aim, the main aim of the present invention is that of indicating a sense amplifier for low-voltage non-volatile memories which can be operated at a supply voltage which is lower than that of the known circuits.

A further aim of the present invention is that of indicating a sense amplifier for low-voltage non-volatile memories which allows to reduce the value of the supply voltage by the amount of the threshold voltage of one of the transistors used as a load.

Another further aim of the present invention is that of indicating a sense amplifier for low-voltage non-volatile memories which allows to make the input voltage of the final amplifying stage relating to the reference cell, independent from the voltage of the corresponding bitline.

Another further aim of the present invention is that of indicating a sense amplifier for non-volatile memories which allows to reduce the supply voltage without reducing the operation speed in respect of the known circuits.

In order to reach the above indicated aims, the present invention is directed to a sense amplifier circuit for low-voltage non-volatile memories having the characteristics indicated in the attached claims, which are integral part of the present description.

Further aims, characteristics and advantages of the present invention will be clear from the following detailed description and from the attached drawings, given only as an explicatory nonlimiting example, wherein:

- figure 1 shows the schematic diagram of a first sense amplifying circuit for non-volatile memories according to the prior art;
- figure 2 shows the schematic diagram of a second sense amplifying circuit for non-volatile memories according to the prior art;

- figure 3 shows the schematic diagram of a sense amplifying circuit for non-volatile memories according to the present invention.

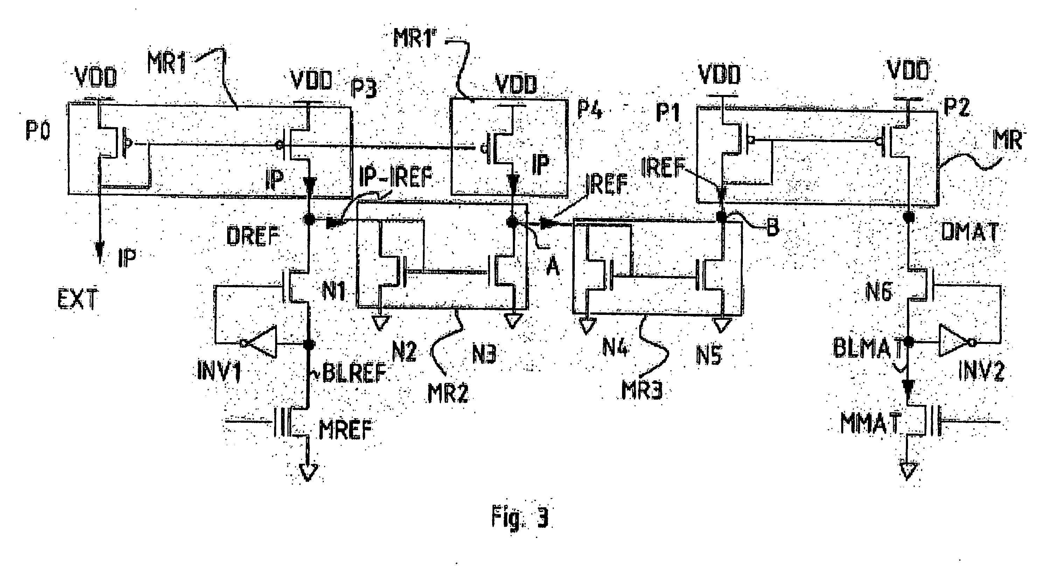

Figures 1 and 2 will not be described anymore because this has already been done above. In figure 3 there is shown a sense amplifier circuit 3 according to the invention. The amplifying stage AMP is not shown in fig. 3 for the sake of simplicity.

The sense amplifier circuit 3 comprises substantially five current mirrors MR1, MR1, MR2, MR3, MR. The current mirror MR1 is constituted by a P-channel MOS transistor P0, the drain of which is connected to a node EXT, to which an external generator, not represented in the figure, is connected; the external generator draws from the node EXT a driving current IP. The transistor P0 is connected as a diode and mirrors the driving current IP into two transistors P3 and P4, of the P-channel MOS type, which cooperate to implement the current mirrors MR1 and MR1'.

The drain of the P3 transistor is connected to the reference node DREF; to the same node, in a similar manner as already described in fig. 1 and 2, there is connected the transistor N1, which, with the associated inverter INV1, performs the task of fixing a determined voltage VBLREF onto the reference bitline BLREF.

To the node DREF there is also connected the current mirror MR2, constituted by the two transistors N2 and N3 of the N-channel MOS type.

The drain of the transistor P4 is connected to a node A, to which there are connected the drain of the transistor N3, which constitutes the output of the current mirror MR2, and the drain of transistor N4 of the N-channel MOS type, which, together with a transistor N5 of the N-channel MOS type, constitutes the current mirror MR3. A last current mirror MR, constituted by transistors P1 and P2, of the P-channel MOS type, is connected to a node B, common to the drains of transistors N5 and P1, and is also connected to the array bitline BLMAT at the node DMAT, where, in similar way as in fig. 1 and 2, there are connected a N-channel MOS transistor N6 and the relevant inverter INV2. Said current mirror MR is the same shown in fig 1.

The sense amplifier circuit 3, operates, as the currents are concerned, as follows.

Transistor N2 draws a current IP-IREF and mirrors it into transistor N3. The drain of transistor N3 is connected to transistor P4, which mirrors the driving current IP, so that from node A towards transistor N4 the reference current IREF is again injected. Said current IREF is mirrored through current mirrors M3 and MR, which is the current mirror which shall mirror the current IREF into the branch of the MAT cells in order to allow the correct operation of the amplifying stage AMP, which has an input connected to node DMAT. Hence the reference current IREF can be compared to the current IMAT in the amplifying stage, in a similar manner as in the circuit of fig. 1.

As the voltages are concerned, however, calling VGIP the voltage on the gate of transistor P3, voltage VCREF at the node DREF shall be low enough to keep the transistors P3 and P4 saturated, so as to guarantee an effective operation of the current mirror MR1. Hence

$$VDREF < VGIP + |VTP3| \qquad (3)$$

We can now express the minimum source-drain voltage of transistor P3, namely VSDP3MIN, as a function of supply voltage VDD and VDREF.

$$VSDP3MIN = VDD - (VGIP + |VTP3|) \qquad (4)$$

If the P channel of transistor P3 is designed broad enough, the sum VGIP+|VTP3| is almost equal to the value of supply voltage VDD, so that the minimum source-drain voltage of transistor P3, namely VSDP3MIN is very small. As a consequence, the condition about the supply voltage VDD of the sense amplifier 3, allowing a correct operation of the reference branch REF is:

$$VDD > VBLREF + VDSN1 + VSDP3MIN \qquad (5)$$

We see that, comparing this condition (5) with condition (1) for the sense amplifier circuit of fig. 1, the threshold voltage VTP3 of transistor P3 is no more present, while the overdrive voltage OVP3 and the minimum source-drain voltage of transistor P3 have approximately equal values. The minimum supply voltage VDD is therefore reduced by an amount equal to the threshold voltage of a P-channel transistor.

Considering now the voltage at the node B, namely VB, we see that said voltage VB, for a correct operation of current mirrors MR3 and MR, shall only comply with condition

$$VB>VA-VTN5 \tag{6}$$

where VA is the voltage at node A and VTN5 is the threshold voltage of transistor N5. As a consequence, for current mirrors MR3 and MR, there are no constraints related to the voltages VBLREF and VBLMAT on the bitlines.

Substantially, in respect of the sense amplifier circuit of fig. 1, there are two differences. The first one is that transistor P3 connected to node DREF is no more in diode configuration and therefore does no more operate as an active load. This allows to eliminate the threshold voltage VTP3. The second one is that, between the node DREF and the current mirror MR, there are inserted two current mirrors MR2 and MR3, which have the purpose of making voltage at node B independent from the voltage VBLREF of the bitline BLREFF.

In order to have a correct operation, as said, the P-channel transistors shall have channels of sufficient width so that the voltage VSDMIN is low. It may be useful, for the same purpose, to provide broad channels in transistors N1 and N6, so that, according to relation (5), it is possible to use a still lower supply voltage VDD.

On the contrary, transistors N2, N3, N4 N5 must have conveniently narrow channels so not to limit voltages VA and VDREF to the threshold values At last, of course, for the correct operation of the sense amplifier circuit 3, the driving current IP shall be selected conveniently greater than the maximum reference current IREF

From this description there are clear the characteristics of the present invention, as well as its advantages.

Conveniently the sense amplifier circuit according to the invention allows a reduced supply voltage in respect of the known circuits, without prejudicing the reference cell operation. The supply voltage reduction corresponds to at least the value of a threshold voltage of a P-channel transistor.

Moreover, said reduction is obtained through a circuit arrangement which does not prejudice the operation speed of the circuit.

Further, the sense amplifier according to the invention allows to render the input voltage of the final amplifying stage pertaining to the reference cell independent from the voltage which controls the operation of the original current mirror, i. e. that connected to the bitline of the cell to be measured

It is clear that many variations to the sense amplifier circuit according to the invention and described as an example are possible for the man skilled in the art, without leaving the novelty principles of the invention, as well as that in the practical implementation the shown details may assume different shapes and be substituted by technically equivalent elements.

For instance, the current mirror ratios may be different from one, in order to perform operations on the current drawn from the reference cells. For instance, in order to use as reference current the mean current of two reference cells connected to the bitline, a transistor P3 may be used, giving a current mirror ratio of one, and a transistor P4, giving a current mirror ratio of 1/2.

Further, providing a mirror ratio of 1/2 in current mirror MR2, we obtain in current mirror MR3 the mean value of the two reference currents of the reference cells. More generally, changing the mirror ratios, we can have in current mirror MR a current which is a function of the reference bitline BLREF current.

**Claims**

1. Sense amplifier circuit (3) for non-volatile memories, of the type apt to draw a reference current from a reference bitline (BLREF) and a cell current from a cell array bitline (BLMAT), and compare them by means of current-voltage converting means and an amplifying stage, said current-voltage converting means comprising also fixing means (N1, INV1, N6, INV2) fixing a determined voltage on the reference bitline (BLREF) and on the cell array bitline (BLMAT), load circuit means (P3, P2) for supplying the reference bitline (BLREF) and the cell array bitline (BLMAT), current mirroring means (MR) for the reference current into an input node of the amplifying stage and for supplying the cell current and the reference current into a further input node of said amplifying stage, wherein the load circuit means (P3) of the reference bitline (BLREF) and the mirroring means (MR) of the reference current are different circuits and wherein a further current mirror circuit (MR1) is provided that comprises a diode connected transistor (P0) and a mirror transistor (P3) controlled by said diode connected transistor (P0) wherein said diode connected transistor (P0) draws a predetermined current (IP) generated outside of the sense amplifier circuit (3), **characterized in that** the reference bitline load circuit means (P3) are represented by said mirroring transistor (P3), in order to have a lower voltage drop on said load circuit means (P3).

2. Sense amplifier circuit (3) for non-volatile memories, according to claim 1, **characterized in that** the load circuit means (P3) of the reference bitline (BLREF) input the predetermined current (IP) into a connecting node (DREF) between the fixing means (N1, INV1) and the mirroring means (MR) and that, between the connecting node(DREF) and the mirroring means (MR), there are provided current compensation circuits (MR2, MR1', MR3) compensating said predetermined current (IP).

3. Sense amplifier circuit (3) for non-volatile memories, according to claim 2, **characterized in that** said current compensation circuits (MR2, MR1', MR3) are realized by means of current mirror circuits.

4. Sense amplifier circuit for non-volatile memories, according to claim 3, **characterized in that** the load circuit means (P3) of the reference bitline (BLREF) are realized by means of a branch of a current mirror (MR1) and that in an other branch of the current mirror (MR1) the predetermined current (IP) is injected.

5. Sense amplifier circuit for non-volatile memories, according to one of the preceding claims 2 to 4, **characterized in that** the current compensation circuits transfer means (MR1', MR2) have a mirroring ratio different from one.

6. Method for sensing a current of a memory cell in non-volatile memories, of a type wherein a comparison is made of a current coming from a reference bit line (BLREF) connected to one or more reference cells with the current coming from a bitline (BLMAT) connected to the memory cell, wherein said comparison is made by mean of current-voltage converting means and an amplifying stage, said current-voltage converting means comprising also fixing means (N1,INV1, N6, INV2) fixing a determined voltage on the reference bitline (BLREF), and on the cell array bit line (BLMAT), wherein current mirroring means (MR) are provided for supplying the reference current into an input node of the amplifying stage (B) and for supplying the cell current and the reference current into a further input node of said amplifying stage (DMAT), wherein load circuit means (P3) of the reference bitline (BLREF) are provided and are different from the mirroring means (MR) of the reference current, and wherein a further current mirror circuit (MR1) is provided that comprises a diode connected transistor (P0) and a mirror transistor (P3) controlled by said diode connected transistor (P0) wherein said diode connected transistor (P0) draws a predetermined current (IP) generated outside of the sense amplifier circuit (3), **characterized in that** the reference bitline load circuit means (P3) are represented by said mirroring transistor (P3), in order to have a lower voltage drop on said load circuit means (P3).

7. Method for sensing the current of a memory cell in non-volatile memories, according to claim 6, **characterized by** the steps of

   a) subtracting from a determined external current (IP) the reference current (IREF) coming from the biasing means (N1,INV1); and
   b) providing current compensation means (MR2, MR1', MR3) apt to supply the reference current (IREF) to the mirroring means (MR) by subtracting the current obtained in step a) from said determined external current (IP).

8. Method for sensing the current of a memory cell in non-volatile memories, according to claim 7, **characterized by** the steps of

   a) drawing the reference current generated by two reference cells;
   b) dividing the current obtained in step a) of claims 7 by two, by means of the said current compensation means (MR2), and adding thereto a half of the said determined external current (IP) in order to obtain a mean value of current supplied by the reference cells.


**Patentansprüche**

1. Leseverstärkerschaltkreis (3) für nicht-flüchtige Speicher, geeignet, einen Referenzstrom aus einer Referenzbitleitung (BLREF) und einen Zellstrom von einer Bitleitung (BLMAT) eines Zellenfeldes aufzunehmen und diese mittels Strom-Spannungs-Umwandlungsmitteln und einer Verstärkungsstufe zu vergleichen, wobei die Strom-Spannungs-Umwandlungsmittel ebenfalls umfassen: Fixierungsmittel (N1, INV1, N6, INV2), die eine bestimmte Spannung auf der Referenzbitleitung (BLREF) und auf der Bitleitung des Zellenfeldes (BLMAT) fixieren, Lastschaltkreismittel (P3, P2), um die Referenzbitleitung (BLREF) und die Bitleitung des Zellenfeldes (BLMAT) zu versorgen, Stromspiegelmittel (MR) für den Referenzstrom in einen Eingabeknoten der Verstärkungsstufe und zum Einspeisen des Zellenstromes und des Referenzstromes in einen weiteren Eingabeknoten der Verstärkungsstufe, wobei die Lastschaltkreismittel (P3) der Referenzbitleitung (BLREF) und der Spiegelmittel (MR) des Referenzstromes verschiedene Schaltkreise sind und wobei ein weiterer Stromspiegelschaltkreis (MR1) vorgesehen ist, der einen Transistor (P0) in Diodenschaltung und einen Spiegeltransistor (P3) umfasst, welcher durch den Transistor (P0) in Diodenschaltung gesteuert wird, wobei der Transistor (P0) in Diodenschaltung einen vorbestimmten Strom (IP) aufweist, welcher außerhalb des Leseverstärkerschaltkreises (3) erzeugt wird, **dadurch gekennzeichnet, dass** die Lastschaltkreismittel (P3) der Referenzbitleitung durch den Spiegeltransistor (P3) repräsentiert sind, um einen geringeren Spannungsabfall über den Lastschaltkreismitteln (P3) zu erhalten.

2. Leseverstärkerschaltkreis (3) für nicht-flüchtige Speicher nach Anspruch 1, **dadurch gekennzeichnet, dass** die Lastschaltkreismittel (P3) der Referenzbitleitung (BLREF) den vorbestimmten Strom (IP) in einen Verbindungsknoten (DREF) zwischen den Fixierungsmitteln (N1, INV1) und den Spiegelmitteln (MR) einspeisen und dass zwischen dem Verbindungsknoten (DREF) und den Spiegelmitteln (MR) Stromkompensationsschaltkreise (MR2, MR1', MR3) vorgesehen sind, welche den vorbestimmten Strom (IP) kompensieren.

3. Leseverstärkerschaltkreis (3) für nicht- flüchtige Speicher nach Anspruch 2, **dadurch gekennzeichnet, dass** die Stromkompensationsschaltkreise (MR2, MR1', MR3) mittels Stromspiegelschaltkreisen realisiert sind.

4. Leseverstärkerschaltkreis für nicht-flüchtige Speicher nach Anspruch 3, **dadurch gekennzeichnet, dass** die Lastschaltkreismittel (P3) der Referenzbitleitung (BLREF) mittels eines Zweiges eines Stromspiegels (MR1) realisiert sind und dass in einem anderen Zweig des Stromspiegels (MR1) der vorbestimmte Strom (IP) eingeprägt ist.

5. Leseverstärkerschaltkreis für nicht-flüchtige Speicher nach einem der vorstehenden Ansprüche 2 bis 4, **dadurch gekennzeichnet, dass** die Stromkompensationsschaltkreistransfermittel (MR1', MR2) ein Spiegelverhältnis verschieden von 1 haben.

6. Verfahren zum Lesen eines Stromes einer Speicherzelle nicht-flüchtiger Speicher eines Typs, bei welchem ein Vergleich eines Stromes, welcher von einer Referenzbitleitung (BLREF) kommt, die mit einer oder mehreren Referenzzellen kontaktiert ist, mit einem Strom durchgeführt wird, welcher von einer Bitleitung (BLMAT) kommt, die mit der Speicherzelle kontaktiert ist, wobei der Vergleich mittels Strom-Spannungs-Umwandlungsmitteln und einer Verstärkungsstufe durchgeführt wird, und wobei die Strom-Spannungs-Umwandlungsmittel ebenfalls umfassen: Fixierungsmittel (N1, INV1, N6, INV2), welche eine bestimmte Spannung auf der Referenzbitleitung (BLREF) und auf der Bitleitung des Zellenfeldes (BLMAT) fixieren, wobei Stromspiegelmittel (MR) vorgesehen sind, um den Referenzstrom in einen Eingabeknoten der Verstärkungsstufe (B) und den Zellenstrom und den Referenzstrom in einen weiteren Eingabeknoten der Verstärkungsstufe (DMAT) einzuspeisen, wobei Lastschaltkreismittel (P3) der Referenzbitleitung (BLREF) vorgesehen sind, die verschieden von den Spiegelmitteln (MR) des Referenzstromes sind, und wobei ein weiterer Stromspiegelschaltkreis (MR1) vorgesehen ist, der einen Transistor (P0) in Diodenschaltung und einen Spiegeltransistor (P3) umfasst, welcher durch den Transistor (P0) in Diodenschaltung gesteuert wird, wobei der Transistor (P0) in Diodenschaltung einen vorbestimmten Strom (IP) aufweist, welcher außerhalb des Leseverstärkerschaltkreises (3) erzeugt wird, **dadurch gekennzeichnet, dass** die Lastschaltkreismittel (P3) der Referenzbitleitung durch den Spiegeltransistor (P3) repräsentiert sind, um einen geringeren Spannungsabfall über den Lastschaltkreismitteln (P3) zu erhalten.

7. Verfahren zum Lesen des Stromes aus einer Speicherzelle nicht-flüchtiger Speicher nach Anspruch 6, **gekennzeichnet durch** die Schritte:

   a) Subtrahieren des Referenzstromes (IREF), welcher von den Arbeitspunkteinstellungsmitteln (N1, INV1) kommt, von einem bestimmten externen Strom (IP); und
   b) Bereitstellen von Stromkompensationsmitteln (MR2, MR1', MR3), welche geeignet sind, den Referenzstrom (IREF) für die Spiegelmittel (MR) **durch** Subtrahieren des Stromes, welcher in Schritt a) aus dem bestimmten externen Strom (IP) erhalten wird, bereitzustellen.

8. Verfahren zum Lesen des Stromes aus einer Speicherzelle nicht-flüchtiger Speicher nach Anspruch 7, **gekennzeichnet durch** die Schritte:

   a) Aufnehmen des Referenzstromes, welcher von zwei Referenzzellen erzeugt wird;
   b) Dividieren **durch** zwei des Stromes, welcher in Schritt a) des Anspruchs 7 erhalten wird, mittels der Stromkompensationsmittel (MR2) und hierzu Hinzuaddieren einer Hälfte des bestimmten externen Stromes (IP), um einen Mittelwert des Stromes zu erhalten, welcher von den Referenzzellen bereitgestellt wird.

**Revendications**

1. Circuit d'amplification de détection (3) pour mémoires non volatiles, du type capable de délivrer un courant de référence depuis une ligne de bit de référence (BLREF) et de délivrer un courant de cellule depuis une matrice de cellule de ligne de bit (BLMAT), et de les comparer au moyen de moyens de conversion courant/tension et au moyen d'un étage d'amplification, lesdits moyens de conversion courant/ tension comprenant en outre des moyens de fixation (N1, INV1, N6, INV2) pour fixer une tension donnée sur la ligne de bit de référence (BLREF) et sur la matrice de cellule de ligne de bit (BLMAT), des moyens formant circuit de charge (P3, P2) destinés à alimenter la ligne de bit de référence (BLREF) et la matrice de cellule de ligne de bit (BLMAT), des moyens formant miroir de courant (MR) pour le courant de référence dans un noeud d'entrée de l'étage d'amplification et destinés à alimenter le courant de cellule et le courant de référence dans un noeud d'entrée supplémentaire dudit étage d'amplification, dans lequel les moyens formant circuit de charge (P3) de la ligne de bit de référence (BLREF) et les moyens formant miroir de courant (MR) du courant de référence sont des circuits distincts et dans lequel est prévu un circuit de miroir de courant supplémentaire (MR1) comprenant un transistor (P0) relié à une diode et un transistor miroir (P3) commandé par ledit transistor (P0) relié à une diode, dans lequel ledit transistor (P0) relié à une diode délivre un courant prédéterminé (IP) généré hors du circuit d'amplification de détection (3), **caractérisé en ce que** les moyens (P3) formant circuit de charge de la ligne de bit de référence sont représentés ledit transistor miroir (P3), afin de réduire la chute de tension desdits moyens formant circuit de charge (P3).

2. Circuit d'amplification de détection (3) pour mémoires non volatiles selon la revendication 1, **caractérisé en ce que** les moyens formant circuit de charge (P3) de la ligne de bit de référence (BLREF) introduise le courant prédéterminé (IP) dans un noeud (DREF) connectant les moyens de fixation (N1, INV1) et les moyens formant miroir de courant (MR), et **en ce qu'**entre le noeud de connexion (DREF) et les moyens formant miroir de courant (MR), des circuits de compensation de courant (MR2, MR1', MR3) sont prévus pour compenser ledit courant prédéterminé (IP).

3. Circuit d'amplification de détection (3) pour mémoires non volatiles selon la revendication 2, **caractérisé en ce que** lesdits circuits de compensation de courant (MR2, MR1', MR3) sont réalisés au moyen de circuits de miroir de courant.

4. Circuit d'amplification de détection pour mémoires non volatiles selon la revendication 3, **caractérisé en ce que** les moyens formant circuit de charge (P3) de la ligne de bit de référence (BLREF) sont réalisés au moyen d'une branche d'un miroir de courant (MR1) et **en ce que** sur une autre branche du miroir du circuit (MR1) le courant prédéterminé (IP) est introduit.

5. Circuit d'amplification de détection (3) pour mémoires non volatiles selon l'une quelconque des revendications 2 à 4, **caractérisé en ce que** le rapport de miroir des moyens de transfert des circuits de compensation de courant (MR1', MR2) est différent de un.

6. Procédé pour détecter le courant d'une cellule de mémoire dans des mémoires non volatiles, du type permettant la comparaison entre un courant provenant d'une ligne de bit de référence (BLREF) connectée à une ou plusieurs cellules de référence et le courant provenant d'une ligne de bit (BLMAT) connectée à la cellule mémoire, dans lequel ladite comparaison est établie grâce à des moyens de conversion courant/tension et d'un étage d'amplification, lesdits moyens de conversion courant/tension comprenant en outre des moyens (N1, INV1, N6, INV2) destinés à fixer une tension déterminée sur la ligne de bit de référence (BLREF) et sur la matrice de cellule de ligne de bit (BLMAT), dans lequel des moyens formant miroir de courant (MR) sont prévus pour fournir le courant de référence dans un noeud d'entrée de l'étage d'amplification (B) et pour fournir le courant de cellule et le courant de référence dans un noeud d'entrée supplémentaire dudit étage d'amplification (DMAT), dans lequel des moyens formant circuit de charge (P3) de la ligne de bit de référence (BLREF) sont prévus et sont distincts des moyens formant miroir de courant (MR) du courant de référence, et dans lequel un circuit de miroir de courant (MR1) supplémentaire est prévu et comprend un transistor (PO) relié à une diode et un transistor miroir (P3) commandé par ledit transistor (PO) relié à une diode dans lequel ledit transistor (PO) relié à une diode délivre un courant prédéterminé (IP) généré hors du circuit d'amplification de détection (3), **caractérisé en ce que** les moyens (P3) formant circuit de charge de la ligne de bit de référence sont représentés par ledit transistor miroir (P3), afin de réduire la chute de tension desdits moyens formant circuit de charge (P3).

7. Procédé pour détecter le courant d'une cellule de mémoire dans des mémoires non volatiles selon la revendication 6, **caractérisé par** les étapes consistant à :

a) Soustraire, d'un courant externe déterminé (IP), le courant de référence (IREF) provenant des moyens de polarisation (N1, INV1) ; et

b) prévoir des moyens de compensation de courant (MR2, MR1', MR3) capables de fournir le courant de référence (IREF) aux moyens formant miroir de courant (MR) par soustraction du courant obtenu à l'étape a) au courant externe déterminé (IP).

8. Procédé pour détecter le courant d'une cellule de mémoire dans des mémoires non volatiles, selon la revendication 7, **caractérisé par** les étapes consistant à :

a) délivrer le courant de référence généré par deux cellules de référence ;

b) diviser par deux le courant obtenu à l'étape a) de la revendication 7, au moyen desdits moyens de compensation de courant (MR2), et additionner celui-ci à la moitié dudit courant externe déterminé (IP) afin d'obtenir une valeur moyenne du courant fourni par les cellules de référence.

Fig. 1

Fig. 2

Fig. 3